# EUROPEAN PATENT SPECIFICATION

(11) **EP 2 206 018 B1**
(45) Date of publication and mention of the grant of the patent: **16.01.2013**
(21) Application number: 08843428.7
(22) Date of filing: 30.10.2008
(51) Int. Cl.: G03F 7/20

(54) **OPTICAL UNIT, ILLUMINATION OPTICAL APPARATUS, EXPOSURE APPARATUS, EXPOSURE METHOD, AND DEVICE MANUFACTURING METHOD**
OPTISCHE EINHEIT, OPTISCHES BELEUCHTUNGSGERÄT, BELICHTUNGSGERÄT, BELICHTUNGSVERFAHREN UND GERÄTEHERSTELLUNGSVERFAHREN
UNITÉ OPTIQUE, APPAREIL D'ÉCLAIRAGE OPTIQUE, APPAREIL D'EXPOSITION, PROCÉDÉ D'EXPOSITION ET PROCÉDÉ DE FABRICATION DE DISPOSITIF

(30) Priority: 31.10.2007 JP 2007282539; 23.05.2008 JP 2008135020
(43) Date of publication of application: 14.07.2010
(73) Proprietor: Nikon Corporation, Tokyo 100-8331 (JP)
(72) Inventor: TANITSU, Osamu, Tokyo 100-8331 (JP)
(74) Representative: HOFFMANN EITLE
(86) International application number: PCT/JP2008/070253
(87) International publication number: WO 2009/057822

(56) References cited:
- EP-A- 1 109 067
- WO-A-2005/026843
- WO-A-2006/035775

## Description

### Technical Field

The present invention relates to an optical unit, an illumination optical apparatus, an exposure apparatus, an exposure method, and a device manufacturing method. More particularly, the present invention relates to an illumination optical apparatus suitably applicable to an exposure apparatus for manufacturing such devices as semiconductor devices, imaging devices, liquid-crystal display devices, and thin-film magnetic heads by lithography.

### Background Art

In a typical exposure apparatus of this type, a light beam emitted from a light source travels through a fly's eye lens as an optical integrator to form a secondary light source (a predetermined light intensity distribution on an illumination pupil in general) as a substantial surface illuminant consisting of a large number of light sources. The light intensity distribution on the illumination pupil will be referred to hereinafter as "pupil intensity distribution." The illumination pupil is defined as a position such that an illumination target surface becomes a Fourier transform surface of the illumination pupil by action of an optical system between the illumination pupil and the illumination target surface (a mask or a wafer in the case of the exposure apparatus).

Beams from the secondary light source are condensed by a condenser lens to superposedly illuminate the mask on which a predetermined pattern is formed. Light passing through the mask travels through a projection optical system to be focused on the wafer, whereby the mask pattern is projected (or transferred) onto the wafer to effect exposure thereof. Since the pattern formed on the mask is a highly integrated one, an even illuminance distribution must be obtained on the wafer in order to accurately transfer this fine pattern onto the wafer.

The exposure apparatus can fail to obtain a desired pupil intensity distribution for some reason and, in turn, the projection optical system can fail to fulfill desired imaging performance. Then the same assignee proposed the technology of disposing a density filter on the illumination pupil plane to correct (or adjust) the pupil intensity distribution (cf. Japanese Patent Application Laid-open No. 2004-247527). WO 2005/026843 discloses an illumination system comprising a spatial light modulator and a diffractive optical element.

### Disclosure of the Invention

Since the conventional technology disclosed in the Application Laid-open No. 2004-247527 is to dispose the filter with a predetermined density distribution (transmittance distribution) on the illumination pupil plane, it had the inconvenience that the pupil intensity distribution could not be adjusted unless the density filter was replaced with another.

The present invention has been accomplished in view of the above-described inconvenience and an object of the present invention is to provide an illumination optical apparatus permitting adjustment of the pupil intensity distribution, without replacement of any optical member. Another object of the present invention is to provide an exposure apparatus and exposure method capable of performing good exposure under a desired illumination condition, using the illumination optical apparatus permitting the adjustment of the pupil intensity distribution.

In order to achieve the above object, a first aspect of the present invention provides an optical unit comprising a first optical path in which a spatial light modulator with a plurality of optical elements arranged two-dimensionally and controlled individually can be arranged; a second optical path being an optical path through which light having traveled through the first optical path does not travel including a mechanism for insertion of an angle distribution providing element with a predetermined fixed pattern on a surface thereof; and a third optical path being an optical path of light having traveled through both of the first optical path and the second optical path, wherein when the angle distribution providing element is inserted in the second optical path, an angle distribution is provided to light exited based on light incident to the angle distribution providing element.
A second aspect of the present invention provides an illumination optical apparatus which illuminates an illumination target surface on the basis of light from a light source, the illumination optical apparatus comprising: the optical unit of the first aspect; and a distribution forming optical system to form a predetermined light intensity distribution on an illumination pupil of the illumination optical apparatus, based on light having traveled via the spatial light modulator and via the angle distribution providing element.

A third aspect of the present invention provides an exposure apparatus comprising the illumination optical apparatus of the second aspect for illuminating a predetermined pattern, which performs exposure of the predetermined pattern on a photosensitive substrate.

A fourth aspect of the present invention provides a device manufacturing method comprising: an exposure step of effecting the exposure of the predetermined pattern on the photosensitive substrate, using the exposure apparatus of the third aspect; a development step of developing the photosensitive substrate onto which the pattern has been transferred, to form a mask layer in a shape corresponding to the pattern on a surface of the photosensitive substrate; and a processing step of processing the surface of the photosensitive substrate through the mask layer.

A fifth aspect of the present invention provides an exposure method of effecting exposure of a predetermined pattern on a photosensitive substrate on the basis of light from a light source, the exposure method comprising: a first step of guiding the light from the light source to an angle distribution providing element to form a predetermined pupil intensity distribution on an illumination pupil; a second step of splitting the light from the light source into a first beam and a second beam different from the first beam, the second beam being directed toward the angle distribution providing element; a third step of guiding the first beam to a spatial light modulator with a plurality of optical elements arranged two-dimensionally and controlled individually; a fourth step of guiding the first beam having traveled via the spatial light modulator, to a position of the illumination pupil; a fifth step of illuminating the predetermined pattern with light having traveled via the illumination pupil; and a sixth step of effecting the exposure on the photosensitive substrate on the basis of light from the predetermined pattern thus illuminated.

A sixth aspect of the present invention provides an electronic device manufacturing method comprising: an exposure step of effecting the exposure of the predetermined pattern on the photosensitive substrate, using the exposure method of the fifth aspect; a development step of developing the photosensitive substrate onto which the pattern has been transferred, to form a mask layer in a shape corresponding to the pattern on a surface of the photosensitive substrate; and a processing step of processing the surface of the photosensitive substrate through the mask layer.

The illumination optical apparatus of the present invention is configured to form the predetermined light intensity distribution on the illumination pupil, based on the beam having traveled via the spatial light modulator with the plurality of optical elements arranged two-dimensionally and controlled individually and the beam having traveled via the angle distribution providing element, for example, like a diffractive optical element. Therefore, a desired pupil intensity distribution can be obtained by correcting the light intensity distribution fixedly formed on the illumination pupil by the angle distribution providing element, by the light intensity distribution variably formed on the illumination pupil by the spatial light modulator.

Namely, the illumination optical apparatus of the present invention permits adjustment of the pupil intensity distribution, without replacement of any optical member. Furthermore, the exposure apparatus of the present invention is able to perform good exposure under a desired illumination condition, using the illumination optical apparatus permitting the adjustment of the pupil intensity distribution, and, therefore, is able to manufacture good devices.

In the exposure method of the present invention, the light from the light source is guided to the angle distribution providing element, for example, like a diffractive optical element to form the predetermined pupil intensity distribution on the illumination pupil. On the other hand, the light from the light source is split into the first beam directed toward the angle distribution providing element, and the second beam different from the first beam, and this second beam is guided to the spatial light modulator with the plurality of optical elements arranged two-dimensionally and controlled individually. The second beam having traveled via the spatial light modulator is guided to the position of the illumination pupil to form the predetermined light intensity distribution on the illumination pupil. The predetermined pattern is illuminated with the light having traveled via the illumination pupil and the exposure on the photosensitive substrate is effected based on the light from the predetermined pattern thus illuminated.

In this manner, a desired pupil intensity distribution can be obtained by correcting the light intensity distribution fixedly formed on the illumination pupil by the angle distribution providing element, by the light intensity distribution variably formed on the illumination pupil by the spatial light modulator. As a consequence, the exposure method of the present invention also permits good exposure to be performed under a desired illumination condition and, therefore, makes it feasible to manufacture good electronic devices.

### Brief Description of the Drawings

Fig. 1 is a drawing schematically showing a configuration of an exposure apparatus according to an embodiment of the present invention.
Fig. 2 is a drawing schematically showing a configuration of a spatial light modulation unit.
Fig. 3 is a perspective view schematically showing a configuration of a cylindrical micro fly's eye lens.
Fig. 4 is a drawing schematically showing a pupil intensity distribution of an annular shape formed in the embodiment and adjustment thereof.
Fig. 5 is a drawing including (a) a view schematically showing an example of forming a pupil intensity distribution of a quadrupolar shape by a diffractive optical element and a spatial light modulator and (b) a view schematically showing an example of forming a pupil intensity distribution of a pentapolar shape by a diffractive optical element and a spatial light modulator.
Fig. 6 is a flowchart showing manufacturing steps of semiconductor devices.
Fig. 7 is a flowchart showing manufacturing steps of a liquid crystal device such as a liquid crystal display device.
Fig. 8 is a drawing showing a schematic configuration of a reflection-type diffractive optical element.

### Best Modes for Carrying Out the Invention

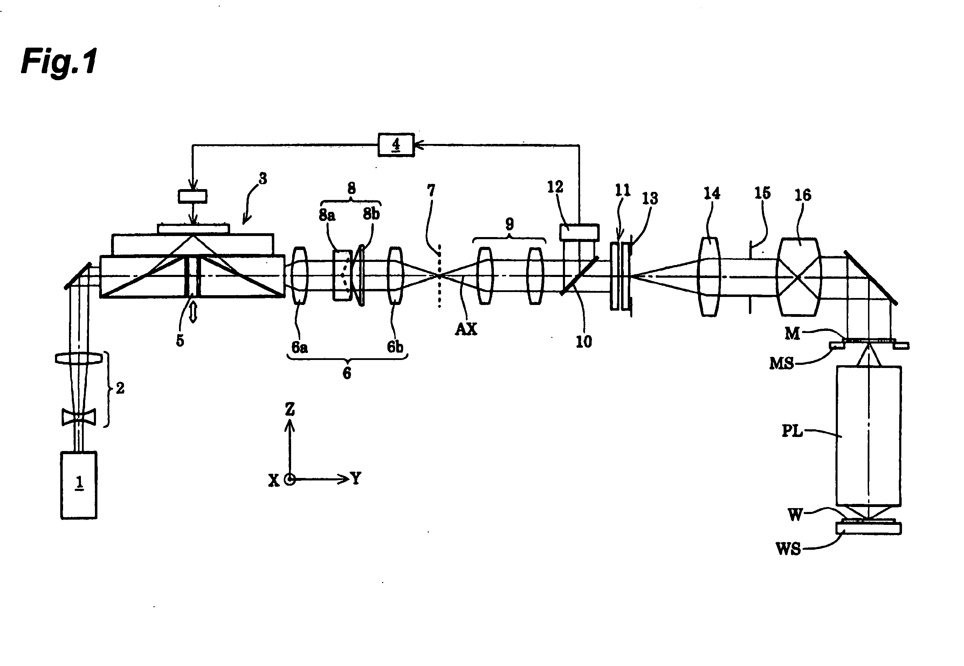

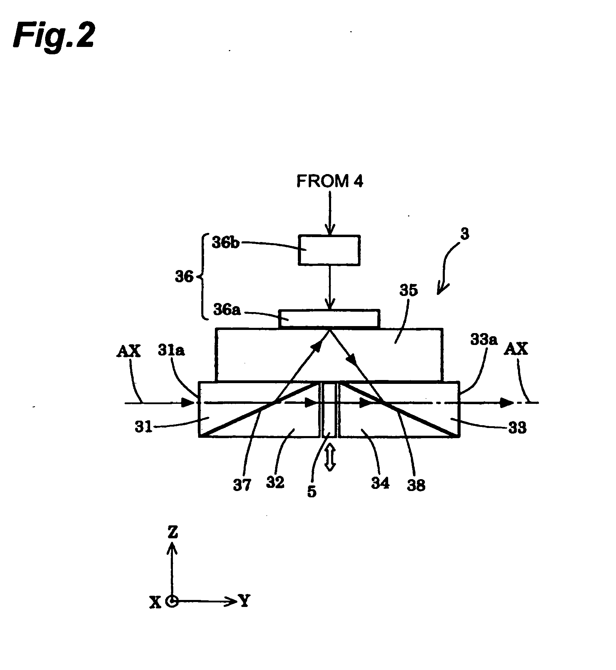

Embodiments of the present invention will be described on the basis of the accompanying drawings. Fig. 1 is a drawing schematically showing a configuration of an exposure apparatus according to an embodiment of the present invention. Fig. 2 is a drawing schematically showing a configuration of a spatial light modulation unit. In Fig. 1, the Z-axis is set along a direction of a normal to a wafer W being a photosensitive substrate, the Y-axis along a direction parallel to the plane of Fig. 1 in a surface of the wafer W, and the X-axis along a direction perpendicular to the plane of Fig. 1 in the surface of the wafer W.

With reference to Fig. 1, a light source 1 supplies exposure light (illumination light) to the exposure apparatus of the present embodiment. The light source 1 can be, for example, an ArF excimer laser light source which supplies light at the wavelength of 193 nm, or a KrF excimer laser light source which supplies light at the wavelength of 248 nm. The light emitted from the light source 1 is expanded into a beam of a required sectional shape by a shaping optical system 2 and the expanded beam is then incident to a spatial light modulation unit 3.

The spatial light modulation unit 3, as shown in Fig. 2, has a pair of rectangular prisms 31 and 32 arranged with their slopes being opposed to each other, another pair of rectangular prisms 33 and 34 arranged with a space in the direction of the optical axis AX from the rectangular prism pair (31, 32) and with their slopes being opposed to each other, a plane-parallel plate 35 arranged in proximity to the two sets of rectangular prism pairs (31, 32) and (33, 34), and a spatial light modulator 36 arranged in proximity to the plane-parallel plate 35.

In the spatial light modulation unit 3, light is incident along the optical axis AX into an entrance surface 31a of the rectangular prism 31, propagates inside the rectangular prism 31, and is then incident to a separation film (beam splitter) 37 formed between the rectangular prisms 31 and 32. The separation film 37 has a function to divide the amplitude of the incident beam into a reflected beam and a transmitted beam. The light reflected on the separation film 37 propagates inside the rectangular prism 31 and the plane-parallel plate 35 and is then incident to the spatial light modulator 36.

The spatial light modulator 36 has a plurality of mirror elements (optical elements in general) 36a arranged two-dimensionally, and a drive unit 36b to individually control and drive the postures of the mirror elements 36a. The drive unit 36b individually controls and drives the postures of the mirror elements 36a in accordance with commands from a control unit 4. The more detailed configuration and action of the spatial light modulator 36 will be described later.

The light reflected by the mirror elements 36a of the spatial light modulator 36 propagates inside the plane-parallel plate 35 and the rectangular prism 33, and is then incident to a separation film 38 formed between the rectangular prisms 33 and 34. The separation film 38 also has a function to divide the amplitude of the incident beam into a reflected beam and a transmitted beam as the separation film 37 does. The light reflected on the separation film 38 propagates inside the rectangular prism 33 and is then exited from an exit surface 33a thereof to the outside of the spatial light modulation unit 3.

In a standard state in which reflecting surfaces of all the mirror elements 36a in the spatial light modulator 36 are positioned along the XY plane, the light having traveled along the optical axis AX into the spatial light modulation unit 3 and having traveled via the spatial light modulator 36 is exited along the optical axis AX from the spatial light modulation unit 3. The light having traveled via the spatial light modulator 36 and having been transmitted by the separation film 38, propagates inside the rectangular prism 34 and is guided as unnecessary light to the outside of the illumination optical path.

On the other hand, the light having traveled along the optical axis AX into the entrance surface 31a of the rectangular prism 31 and having been transmitted by the separation film 37, propagates inside the rectangular prism 32 and is then incident to a diffractive optical element 5 arranged in the illumination optical path between the rectangular prism pairs (31, 32) and (33, 34). The diffractive optical element 5 is configured to be optionally inserted into or retracted from the illumination optical path and configured to be replaceable with another diffractive optical element that forms a different light intensity distribution in its far field (far field region).

The insertion/retraction of the diffractive optical element 5 with respect to the illumination optical path is carried out in accordance with a command from the control unit 4. In general, a diffractive optical element is made by forming level differences with a pitch approximately equal to the wavelength of the exposure light (illumination light) in a substrate and has an action to diffract an incident beam at desired angles. For easier understanding of the basic operation of the exposure apparatus, the action of the spatial light modulator 36 will be ignored and it will be assumed hereinafter that the diffractive optical element 5 is one for annular illumination.

The light having passed through the diffractive optical element 5 propagates inside the rectangular prism 34 and is then incident to the separation film 38. The light having traveled through the diffractive optical element 5 and through the separation film 38 propagates inside the rectangular prism 33 and is then exited from the exit surface 33a thereof to the outside of the spatial light modulation unit 3. Namely, the light having traveled along the optical axis AX into the spatial light modulation unit 3 and having traveled through the diffractive optical element 5 is exited along the optical axis AX from the spatial light modulation unit 3. The light having traveled through the diffractive optical element 5 and having been reflected by the separation film 38 propagates inside the rectangular prism 34 and is then guided as unnecessary light to the outside of the illumination optical path.

In the spatial light modulation unit 3, as described above, the separation film 37 formed between the rectangular prisms 31 and 32 constitutes a light splitter to split the incident beam into two beams (a plurality of beams in general). The separation film 38 formed between the rectangular prisms 33 and 34 constitutes a light combiner to combine the light having traveled via the spatial light modulator 36 and the light having traveled via the diffractive optical element 5 as an angle distribution providing element. The light exited from the spatial light modulation unit 3 is then incident to an afocal lens 6.

The optical path extending from the separation film 37 to the separation film 38 and via the mirror elements 36a of the spatial light modulator 36 is defined as a first optical path. The optical path extending from the separation film 37 to the separation film 38 and having a mechanism for insertion of the diffractive optical element 5 is defined as a second optical path. The optical path of the light exited from the separation film 38 and having traveled through both of the first optical path and the second optical path is defined as a third optical path. As shown in Fig. 2, the mechanism for insertion of the diffractive optical element 5 in the second optical path has a space for insertion of the diffractive optical element 5. The optical path refers to a path in which light is intended to pass in a use state.

The diffractive optical element 5 for annular illumination has such a function that when a parallel beam with a rectangular cross section is incident thereto, it divides the wavefront of the beam and forms a light intensity distribution of an annular shape in its far field (or Fraunhofer diffraction region). The afocal lens 6 is an afocal system (afocal optic) so set that a front focal point thereof is approximately coincident with the position of the mirror elements 36a of the spatial light modulator 36 and with the position of the diffractive optical element 5 and that a rear focal point thereof is approximately coincident with a position of a predetermined plane 7 indicated by a dashed line in the drawing.

Therefore, a nearly parallel beam incident to the diffractive optical element 5 forms a light intensity distribution of an annular shape on a pupil plane of the afocal lens 6 and light is then exited in an annular angle distribution from the afocal lens 6.

As described above, the diffractive optical element 5 can function as an angle distribution providing element with a predetermined fixed pattern on its surface. Namely, when the diffractive optical element 5 is inserted in the second optical path, an angle distribution is provided to the light exited based on the light incident to the diffractive optical element 5. A light-dark pattern such as a light-shield pattern or a darkening pattern, or a phase pattern such as a level-difference pattern of a surface can be used as the predetermined fixed pattern of the diffractive optical element.

A conical axicon system 8 is arranged at the position of the pupil plane of the afocal lens 6 or at a position near it in the optical path between a front lens unit 6a and a rear lens unit 6b of the afocal lens 6. The configuration and action of the conical axicon system 8 will be described later.

The beam having traveled through the afocal lens 6 travels through a zoom lens 9 for variation in σ value (σ value = mask-side numerical aperture of the illumination optical apparatus/mask-side numerical aperture of the projection optical system) and then enters a beam splitter 10. The light transmitted by the beam splitter 10 travels along the illumination optical path to enter a cylindrical micro fly's eye lens 11. On the other hand, the light reflected by the beam splitter 10 is guided to the outside of the illumination optical path to enter an illumination pupil distribution measuring unit 12.

The illumination pupil distribution measuring unit 12 has, for example, a CCD imaging unit with an image pickup surface arranged at a position optically conjugate with an entrance surface of the cylindrical micro fly's eye lens 11, and monitors a light intensity distribution formed on the entrance surface of the cylindrical micro fly's eye lens 11. Namely, the illumination pupil distribution measuring unit 12 has a function to measure the pupil intensity distribution on the illumination pupil or on the plane optically conjugate with the illumination pupil. The result of the measurement by the illumination pupil distribution measuring unit 12 is fed to the control unit 4. Concerning the detailed configuration and action of the illumination pupil distribution measuring unit 12, reference can be made, for example, to Japanese Patent Application Laid-open No. 2006-054328 and U.S. Pat. Published Application No. 2008/0030707.

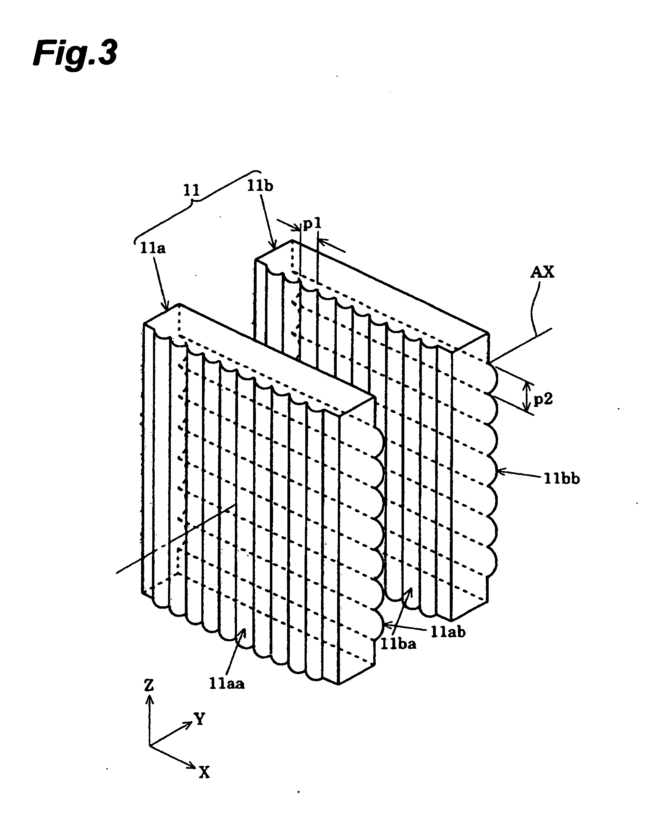

The cylindrical micro fly's eye lens 11, as shown in Fig. 3, is composed of a first fly's eye member 11 a arranged on the light source side and a second fly's eye member 11b arranged on the mask side. Cylindrical lens groups 11aa and 11ba arrayed in the X-direction are formed each at the pitch p1 in the light-source-side surface of the first fly's eye member 11 a and in the light-source-side surface of the second fly's eye member 11b, respectively. Cylindrical lens groups 11ab and 11bb arrayed in the Z-direction are formed each at the pitch p2 (p2 > p1) in the mask-side surface of the first fly's eye member 11a and in the mask-side surface of the second fly's eye member 11b, respectively

When attention is focused on the refracting action in the X-direction of the cylindrical micro fly's eye lens 11 (i.e., the refracting action in the XY plane), the wavefront of a parallel beam incident along the optical axis AX is divided at the pitch p1 along the X-direction by the cylindrical lens group 11aa formed on the light source side of the first fly's eye member 11a, the divided beams are condensed by refracting faces of the cylindrical lens group, the condensed beams are then condensed by refracting faces of the corresponding cylindrical lenses in the cylindrical lens group 11ba formed on the light source side of the second fly's eye member 11b, and the condensed beams are converged on the rear focal plane of the cylindrical micro fly's eye lens 11.

When attention is focused on the refracting action in the Z-direction of the cylindrical micro fly's eye lens 11 (i.e., the refracting action in the YZ plane), the wavefront of a parallel beam incident along the optical axis AX is divided at the pitch p2 along the Z-direction by the cylindrical lens group 11ab formed on the mask side of the first fly's eye member 11 a, the divided beams are condensed by refracting faces of the cylindrical lens group, the condensed beams are then condensed by refracting faces of the corresponding cylindrical lenses in the cylindrical lens group 11bb formed on the mask side of the second fly's eye member 11b, and the condensed beams are converged on the rear focal plane of the cylindrical micro fly's eye lens 11.

As described above, the cylindrical micro fly's eye lens 11 is composed of the first fly's eye member 11a and the second fly's eye member 11b in each of which the cylindrical lens groups are arranged on the two side faces thereof, and exercises the same optical function as a micro fly's eye lens in which a large number of micro refracting faces of a rectangular shape in the size of p1 in the X-direction and in the size of p2 in the Z-direction are integrally formed horizontally and vertically and densely. The cylindrical micro fly's eye lens 11 is able to achieve smaller change in distortion due to variation in surface shapes of the micro refracting faces and, for example, to keep less influence on the illuminance distribution from manufacture errors of the large number of micro refracting faces integrally formed by etching.

The position of the predetermined plane 7 is located near the front focal point of the zoom lens 9 and the entrance surface of the cylindrical micro fly's eye lens 11 is located near the rear focal point of the zoom lens 9. In other words, the zoom lens 9 sets the predetermined plane 7 and the entrance surface of the cylindrical micro fly's eye lens 11 substantially in the Fourier transform relation and, thus, keeps the pupil plane of the afocal lens 6 approximately optically conjugate with the entrance surface of the cylindrical micro fly's eye lens 11.

Therefore, for example, an annular illumination field centered on the optical axis AX is formed on the entrance surface of the cylindrical micro fly's eye lens 11 as on the pupil plane of the afocal lens 6. The overall shape of this annular illumination field similarly varies depending upon the focal length of the zoom lens 9. The rectangular micro refracting faces as wavefront division units in the cylindrical micro fly's eye lens 11 are of a rectangular shape similar to a shape of an illumination field to be formed on the mask M (and, therefore, similar to a shape of an exposure region to be formed on the wafer W).

The beam incident to the cylindrical micro fly's eye lens 11 is two-dimensionally divided to form a secondary light source with a light intensity distribution approximately identical with the illumination field formed by the incident beam, i.e., a secondary light source consisting of a substantial surface illuminant of an annular shape centered on the optical axis AX (annular pupil intensity distribution), on or near its rear focal plane (and thus on the illumination pupil). A beam from the secondary light source formed on or near the rear focal plane of the cylindrical micro fly's eye lens 11 is then incident to an aperture stop 13 located near it.

The aperture stop 13 has an annular aperture (light transmitting portion) corresponding to the secondary light source of the annular shape formed on or near the rear focal plane of the cylindrical micro fly's eye lens 11. The aperture stop 13 is configured so as to be detachable with respect to the illumination optical path and to be switchable with a plurality of aperture stops having apertures of different sizes and shapes. A method of switching the aperture stops can be, for example, a known turret method or slide method. The aperture stop 13 is arranged at a position approximately optically conjugate with an entrance pupil plane of the projection optical system PL described later, and defines a range of the secondary light source that contributes to illumination.

The beams from the secondary light source limited by the aperture stop 13 travel through a condenser optical system 14 to superposedly illuminate a mask blind 15. In this way, an illumination field of a rectangular shape according to the shape and focal length of the rectangular micro refracting faces as wavefront division units of the cylindrical micro fly's eye lens 11 is formed on the mask blind 15 as an illumination field stop. The beams having passed through a rectangular aperture (light transmitting portion) of the mask blind 15 are condensed by an imaging optical system 16 to superposedly illuminate the mask M on which a predetermined pattern is formed. Namely, the imaging optical system 16 forms an image of the rectangular aperture of the mask blind 15 on the mask M.

A beam having passed through the mask M held on a mask stage MS travels through the projection optical system PL to form an image of the mask pattern on the wafer (photosensitive substrate) W held on a wafer stage WS. In this manner, the pattern of the mask M is sequentially transferred into each of exposure regions on the wafer W by performing one-shot exposure or scan exposure while two-dimensionally driving and controlling the wafer stage WS in the plane (XY plane) perpendicular to the optical axis AX of the projection optical system PL and, therefore, while two-dimensionally driving and controlling the wafer W.

When the diffractive optical element 5 for annular illumination is replaced with another diffractive optical element having an appropriate characteristic, e.g., a diffractive optical element for multi-pole illumination (e.g., for dipole illumination, for quadrupole illumination, for octupole illumination, or the like) or a diffractive optical element for circular illumination in the illumination optical path, it is feasible to implement a variety of modified illuminations. A switching method among the diffractive optical elements can be, for example, one of the well-known turret method and slide method.

The conical axicon system 8 is composed of the following members arranged in the order named from the light source side: first prism member 8a with a plane on the light source side and with a refracting surface of a concave conical shape on the mask side; and second prism member 8b with a plane on the mask side and with a refracting surface of a convex conical shape on the light source side. The concave conical refracting surface of the first prism member 8a and the convex conical refracting surface of the second prism member 8b are complementarily formed so as to be able to contact each other. At least one member out of the first prism member 8a and the second prism member 8b is configured to be movable along the optical axis AX, whereby the spacing is made variable between the concave conical refracting surface of the first prism member 8a and the convex conical refracting surface of the second prism member 8b. For easier understanding, the action of the conical axicon system 8 and the action of the zoom lens 9 will be described with focus on the secondary light source of the annular or quadrupolar shape.

In a state in which the concave conical refracting surface of the first prism member 8a and the convex conical refracting surface of the second prism member 8b contact each other, the conical axicon system 8 functions as a plane-parallel plate and causes no effect on the secondary light source of the quadrupolar or annular shape formed. However, as the concave conical refracting surface of the first prism member 8a and the convex conical refracting surface of the second prism member 8b are separated away from each other, the outside diameter (inside diameter) of the annular or quadrupolar secondary light source varies while keeping constant the width of the annular or quadrupolar secondary light source (half of a difference between the outside diameter and the inside diameter of the annular secondary light source; or half of a difference between a diameter (outside diameter) of a circle circumscribed to the quadrupolar secondary light source and a diameter (inside diameter) of a circle inscribed therein). Namely, the annular ratio (inside diameter/outside diameter) and the size (outside diameter) of the annular or quadrupolar secondary light source vary.

The zoom lens 9 has a function to enlarge or reduce the overall shape of the annular or quadrupolar secondary light source similarly (or isotropically). For example, as the focal length of the zoom lens 9 is increased from a minimum value to a predetermined value, the overall shape of the annular or quadrupolar secondary light source is similarly enlarged. In other words, the width and size (outside diameter) of the secondary light source both vary, without change in the annular ratio of the annular or quadrupolar secondary light source, by the action of the zoom lens 9. In this manner, the annular ratio and size (outside diameter) of the annular or quadrupolar secondary light source can be controlled by the actions of the conical axicon system 8 and the zoom lens 9.

In the present embodiment, the spatial light modulator 36 to be used can be, for example, one continuously changing each of orientations of the mirror elements 36a arranged two-dimensionally. Such a spatial light modulator can be selected, for example, from the spatial light modulators disclosed in Japanese Patent Application Laid-open (Translation of PCT Application) No. 10-503300 and European Patent Application Publication EP 779530 corresponding thereto, Japanese Patent Application Laid-open No. 2004-78136 and U.S. Pat. No. 6,900,915 corresponding thereto, Japanese Patent Application Laid-open (Translation of PCT Application) No. 2006-524349 and U.S. Pat. No. 7,095,546 corresponding thereto, and Japanese Patent Application Laid-open No. 2006-113437.

In the spatial light modulator 36, each of the postures of the mirror elements 36a is varied by the action of the drive unit 36b operating according to a control signal from the control unit 4, whereby each mirror element 36a is set in a predetermined orientation. The light reflected at predetermined angles by the mirror elements 36a of the spatial light modulator 36 forms a predetermined light intensity distribution on the pupil plane of the afocal lens 6, on the entrance surface of the cylindrical micro fly's eye lens 11, and on the rear focal plane of the cylindrical micro fly's eye lens 11 or on the illumination pupil near it (the position where the aperture stop 13 is arranged).

Namely, the afocal lens 6, zoom lens 9, and cylindrical micro fly's eye lens 11 constitute a distribution forming optical system which forms a predetermined light intensity distribution on the illumination pupil of the illumination optical apparatus (2-16), based on the beam having traveled via the spatial light modulator 36 and the beam having traveled via the diffractive optical element (angle distribution providing element) 5. Furthermore, the light intensity distribution corresponding to the predetermined light intensity distribution is also formed at other illumination pupil positions optically conjugate with the aperture stop 13, i.e., at the pupil position of the imaging optical system 16 and at the pupil position of the projection optical system PL.

It is important for the exposure apparatus to perform exposure under an appropriate illumination condition according to a pattern characteristic, in order to highly accurately and faithfully transfer the pattern of the mask M onto the wafer W. For this purpose, it is necessary to form a desired light intensity distribution on the illumination pupil of the illumination optical apparatus (2-16) and, therefore, on the pupil plane of the projection optical system PL. However, the exposure apparatus can fail to obtain the desired pupil intensity distribution for some reason and, in turn, the projection optical system PL can fail to fulfill the desired imaging performance, as described previously.

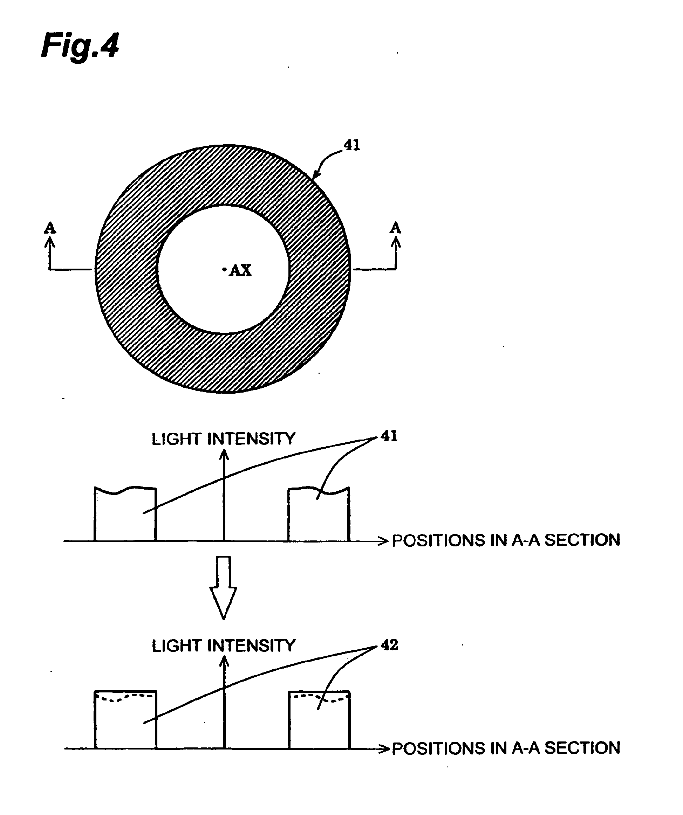

As an example, as shown in Fig. 4, the shape and size of the annular pupil intensity distribution 41 formed by the diffractive optical element 5 are desired ones, whereas the intensity along section A-A is not uniform but uneven. In the present embodiment, the illumination pupil distribution measuring unit 12 measures the light intensity distribution corresponding to the annular pupil intensity distribution 41 formed by the diffractive optical element 5 and feeds the measurement result (shape, size, unevenness of intensity, etc.) to the control unit 4.

The control unit 4 feeds a control signal to control the spatial light modulator 36 in the spatial light modulation unit 3, based on the measurement result from the illumination pupil distribution measuring unit 12, to the drive unit 36b of the spatial light modulator 36. The drive unit 36b varies each of the postures of the mirror elements 36a in accordance with commands from the control unit 4 to set each mirror element 36a in a predetermined orientation. In this manner, a desired pupil intensity distribution 42 can be obtained by correcting the unevenness of intensity of the annular pupil intensity distribution 41 formed by the diffractive optical element 5, by action of the spatial light modulator 36. This configuration permits the apparatus to stably obtain the desired pupil intensity distribution 42 even when there is a secular change in unevenness of the pupil intensity distribution due to deterioration of optical members (light transmitting members and reflecting members) in the illumination optical apparatus (2-16), pollution, or the like, or a secular change in the light intensity distribution of the light from the light source 1.

As described above, the illumination optical apparatus (2-16) of the present embodiment forms the predetermined light intensity distribution on the illumination pupil, based on the beam having traveled via the spatial light modulator 36 with the mirror elements (optical elements) 36a arranged two-dimensionally and controlled individually and the beam having traveled via the diffractive optical element (angle distribution providing element) 5. Therefore, the desired pupil intensity distribution can be obtained by correcting the light intensity distribution formed on the illumination pupil by the diffractive optical element 5, by the light intensity distribution variably formed on the illumination pupil by the spatial light modulator 36.

Namely, the illumination optical apparatus (2-16) of the present embodiment, different, for example, from the conventional technology of replacing the density filter with another, permits the pupil intensity distribution to be adjusted into a desired state, without replacement of any optical member. The exposure apparatus (2-WS) of the present embodiment is able to perform good exposure under a desired illumination condition, using the illumination optical apparatus (2-16) permitting the adjustment of the pupil intensity distribution into the desired state.

In the present embodiment, when the spatial light modulator 36 is in the standard state, the traveling direction of the incident beam to the separation film 37 functioning as a light splitter is parallel to (or coincident with) the traveling direction of the exiting beam from the separation film 38 functioning as a light combiner. In other words, in the standard state of the spatial light modulator 36, the traveling directions of the incident beam to the spatial light modulation unit 3 and the exiting beam from the spatial light modulation unit 3 are coincident with (or parallel to) the optical axis AX of the illumination optical apparatus. Since the optical paths upstream and downstream of the spatial light modulation unit 3 are coaxial (or parallel) as described above, the optical system can be shared, for example, with the conventional illumination optical apparatus using a diffractive optical element for formation of the pupil intensity distribution.

In the present embodiment, the mirror elements 36a of the spatial light modulator 36 are arranged in proximity to the plane-parallel plate 35. In this case, the plane-parallel plate 35 serves as a cover member for the mirror elements 36a, which can improve the durability of the spatial light modulator 36.

For easier understanding of the operational effect of the embodiment, the above description presents the simple example in which the pupil intensity distribution 41 formed by the diffractive optical element 5 has the desired shape and size. However, without having to be limited to this, the shape, size, unevenness of intensity, etc. of the pupil intensity distribution formed by the diffractive optical element 5 can be corrected (or adjusted) by the light intensity distribution variably formed on the illumination pupil by the spatial light modulator 36. In this case, it is also possible to positively deform the shape of the light intensity distribution or to positively disorder evenness of intensity of the pupil intensity distribution to make it uneven, if necessary.

In the above description, the light intensity distribution formed on the illumination pupil by the diffractive optical element 5 is corrected by the light intensity distribution variably formed on the illumination pupil by the spatial light modulator 36. However, without having to be limited to this, it is also possible to form a pupil intensity distribution consisting of a light intensity distribution formed in a first region on the illumination pupil by the diffractive optical element 5 and a light intensity distribution formed in a second region (another region different from the first region) on the illumination pupil by the spatial light modulator 36.

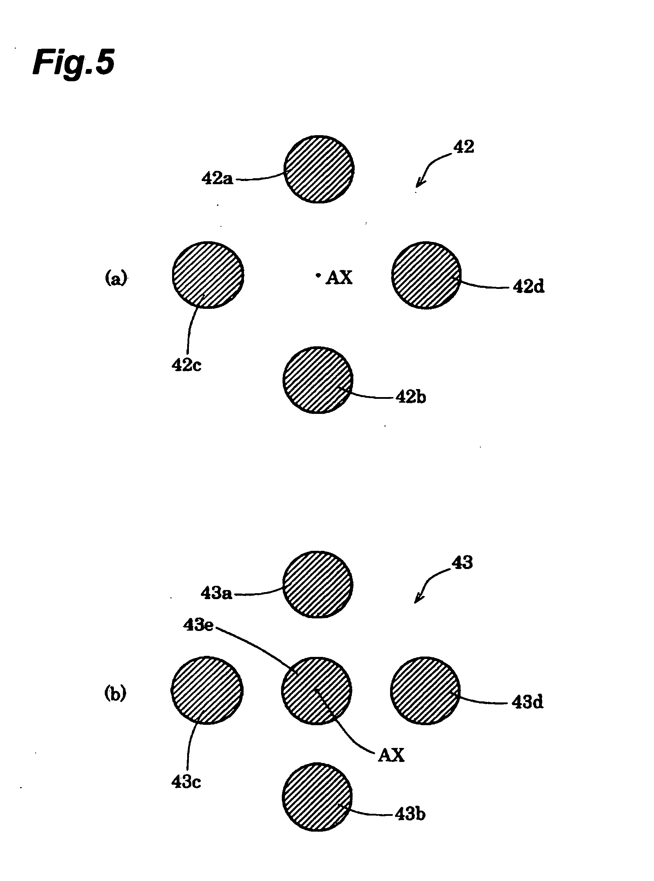

Specifically, it is possible, for example as shown in Fig. 5 (a), to form a pupil intensity distribution 42 of a quadrupolar shape consisting of light intensity distributional areas 42a, 42b of a dipolar shape formed on the illumination pupil by the diffractive optical element 5 and light intensity distributional areas 42c, 42d of a dipolar shape formed on the illumination pupil by the spatial light modulator 36. As another example, for example as shown in Fig. 5 (b), it is also possible to form a pupil intensity distribution 43 of a pentapolar shape consisting of light intensity distributional areas 43a-43d of a quadrupolar shape formed on the illumination pupil by the diffractive optical element 5 and a light intensity distributional area 43e of a center monopolar shape formed on the illumination pupil by the spatial light modulator 36.

It is noted herein that the light intensity distribution formed in the first region on the illumination pupil by the diffractive optical element 5 and the light intensity distribution formed in the second region on the illumination pupil by the spatial light modulator 36 may overlap in part. Namely, the first region and the second region may overlap in part.

The change in the pupil intensity distribution by the spatial light modulator 36 as described above may be modified, for example, according to positions on the mask M during execution of scan exposure. Specifically, in a case where there are a plurality of pattern regions on the mask M, the illumination may be made in such a manner that a predetermined pattern region is illuminated, for example, with the pupil intensity distribution 42 of Fig. 5 (a) and that another pattern region different from the predetermined pattern region is illuminated with the pupil intensity distribution 43 of Fig. 5 (b). Since the pupil intensity distribution by the spatial light modulator 36 can be changed in an extremely short time (almost instantaneously), an optimal illumination condition can be provided for each of the pattern regions on the mask M, without reduction in throughput.

In the above description, the spatial light modulator with the plurality of optical elements arranged two-dimensionally and controlled individually is the one in which the orientations (angles: inclinations) of the reflecting surfaces arranged two-dimensionally can be individually controlled. However, without having to be limited to this, it is also possible, for example, to use a spatial light modulator in which heights (positions) of the reflecting surfaces arranged two-dimensionally can be individually controlled. The spatial light modulator of this type applicable herein can be selected, for example, from the spatial light modulators disclosed in Japanese Patent Application Laid-open No. 6-281869 and U.S. Pat. No. 5,312,513 corresponding thereto, and in Fig. 1d in Japanese Patent Application Laid-open (Translation of PCT Application) No. 2004-520618 and U.S. Pat. No. 6,885,493 corresponding thereto. These spatial light modulators are able to apply the same action as a diffracting surface, to the incident light by forming a two-dimensional height distribution. The above-described spatial light modulator with the plurality of reflecting surfaces arranged two-dimensionally may be modified, for example, according to the disclosure in Japanese Patent Application Laid-open (Translation of PCT Application) No. 2006-513442 and U.S. Pat. No. 6,891,655 corresponding thereto, or according to the disclosure in Japanese Patent Application Laid-open (Translation of PCT Application) No. 2005-524112 and U.S. Pat. Published Application No. 2005/0095749 corresponding thereto.

In the above description, the spatial light modulator used is the reflective spatial light modulator with the plurality of mirror elements, but, without having to be limited to this, it is also possible, for example, to use the transmissive spatial light modulator disclosed in U.S. Pat. No. 5,229,872.

In the above description, the diffractive optical element 5 replaceably inserted in the illumination optical path in the spatial light modulation unit 3 is the transmissive diffractive optical element in which a phase type or amplitude type diffraction pattern is formed on a surface of an optically transparent substrate. However, without having to be limited to this, the transmissive diffractive optical element can be replaced by a reflective diffractive optical element, a transmissive refracting optical element, a reflective optical element, or the like.

In the reflective diffractive optical element, a phase type or amplitude type diffraction pattern is formed on a surface of a substrate. In passing, the amplitude type diffraction pattern of the transmissive diffractive optical element is a light shield pattern on a surface of an optically transparent substrate, and the amplitude type diffraction pattern of the reflective diffractive optical element is a reflecting pattern on a surface of a substrate. In the transmissive refracting optical element, a refracting surfaces with a predetermined shape such as a lens surfaces or a prism surfaces are formed on a surface of an optically transparent substrate. On the other hand, in the reflective refracting optical element, a mirror surfaces of a curved shape or a wedge shape are formed on a surface of a substrate.

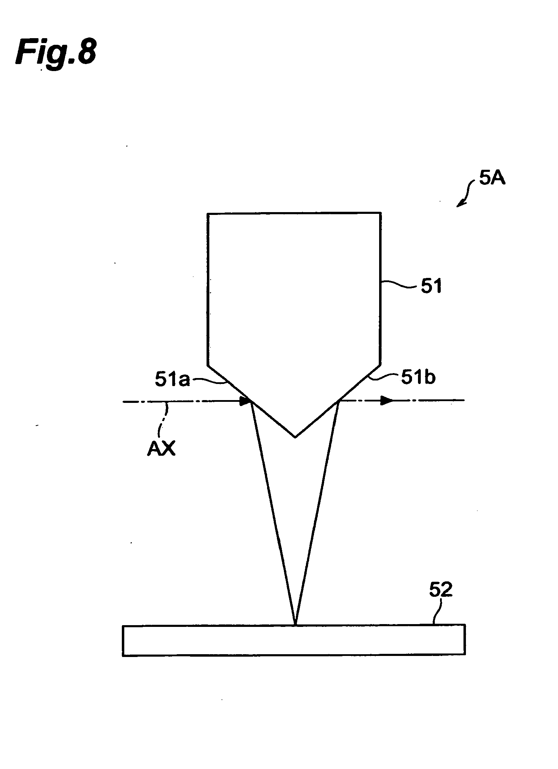

Fig. 8 shows a configuration of a reflection type diffraction optical device 5A. As shown in Fig. 8, the reflective diffraction optical device 5A consists of a prism 51 and a reflective diffractive optical element 52. The diffraction optical device 5A is configured so that it can be inserted in the second optical path, for example, instead of the diffractive optical element 5 in Fig. 1. Namely, as shown in Fig. 8, the light transmitted by the separation film 37 is reflected on a reflecting surface 51a of prism 51 and is then incident to the reflective diffractive optical element 52. The light reflected on the reflective diffractive optical element 52 is reflected on a reflecting surface 51b of prism 51 and is then incident to the separation film 38.

In the above embodiment, the spatial light modulation unit 3 is composed of the two sets of rectangular prism pairs (31, 32; 33, 34), the plane-parallel plate 35, and the spatial light modulator 36. However, without having to be limited to this, it is possible to contemplate various forms for specific configurations of the spatial light modulation unit 3.

In the above embodiment, the separation film 37 for effecting the amplitude division of the beam functions as a light splitter and the separation film 38 to implement the amplitude division of the beam functions as a light combiner. However, without having to be limited to this, it is also possible to use polarization separating films as a light splitter and a light combiner. In this case, the pupil intensity distribution formed is one consisting of a first light intensity distribution in a first polarization state (e.g., s-polarized light) formed on the illumination pupil by the diffractive optical element 5 and a second light intensity distribution in a second polarization state (e.g., p-polarized light) formed on the illumination pupil by the spatial light modulator 36.

In the aforementioned embodiment, the mask can be replaced by a variable pattern forming device which forms a predetermined pattern on the basis of predetermined electronic data. The use of this variable pattern forming device minimizes the effect on synchronization accuracy even when the pattern surface is set vertical. The variable pattern forming device applicable herein can be, for example, a DMD (Digital Micromirror Device) including a plurality of reflecting elements driven based on predetermined electronic data. The exposure apparatus using DMD is disclosed, for example, in Japanese Patent Application Laid-open No. 2004-304135 and International Publication WO2006/080285 and U.S. Pat. Published Application No. 2007/0296936 corresponding thereto. Besides the reflective spatial light modulators of the non-emission type like DMD, it is also possible to use a transmissive spatial light modulator or to use a self-emission type image display device. The variable pattern forming device may also be used in cases where the pattern surface is set horizontal.

In the exposure method of the present embodiment, as described above, the light from the light source 1 is guided to the diffractive optical element 5 as an angle distribution providing element to form the predetermined pupil intensity distribution on the illumination pupil. On the other hand, the light from the light source 1 is split into the first beam directed toward the diffractive optical element 5 and the second beam different from the first beam, and this second beam is guided to the spatial light modulator 36 with the mirror elements 36a arranged two-dimensionally and controlled individually. The second beam having traveled via the spatial light modulator 36 is guided to the position of the illumination pupil to form the predetermined light intensity distribution on the illumination pupil.

The pattern on the mask M is illuminated with the light having traveled through the illumination pupil and exposure on the wafer W as a photosensitive substrate is effected based on the light from the pattern on the mask M thus illuminated. In this manner, the desired pupil intensity distribution is obtained by correcting the light intensity distribution fixedly formed on the illumination pupil by the diffractive optical element 5, by the light intensity distribution variably formed on the illumination pupil by the spatial light modulator 36. As a consequence, good exposure is also performed under the desired illumination condition by the exposure method of the present embodiment.

In the exposure method of the present embodiment, as described above, the predetermined light intensity distribution formed on the illumination pupil is measured and the light modulation by the spatial light modulator 36 can be controlled based on the result of the measurement. It is also possible to control the light modulation by the spatial light modulator 36 as follows: an exposed pattern transferred onto the wafer W as a photosensitive substrate is measured, it is determined whether the exposed pattern is within a permissible range, and the light modulation is controlled when the exposed pattern is determined to be off the permissible range.

In this case, specifically, actual exposure is performed on a wafer W coated with a resist (photosensitive material), the exposed wafer W is developed, and the developed resist pattern is measured. Alternatively, the surface of the wafer W is processed using the resist pattern as a hard mask and the pattern on the processed wafer W is measured. This processing includes, for example, at least one of etching of the surface of the wafer W and deposition of a metal film or the like.

Thereafter, it is determined whether the exposed pattern (at least one pattern out of the resist pattern and the pattern on the processed wafer W) is within a permissible range for a real device pattern to be obtained. The permissive range herein may be a permissible range for errors in shape between the real device pattern to be obtained, and the exposed pattern. It is also possible to use the pattern on the processed wafer W as the exposed pattern, in order to determine the permissible range in consideration of errors and others during the processing on the surface of the wafer W subsequently carried out after the exposure step.

The exposure apparatus according to the foregoing embodiment is manufactured by assembling various sub-systems containing their respective components as set forth in the scope of claims in the present application, so as to maintain predetermined mechanical accuracy, electrical accuracy, and optical accuracy. For ensuring these various accuracies, the following adjustments are carried out before and after the assembling: adjustment for achieving the optical accuracy for various optical systems; adjustment for achieving the mechanical accuracy for various mechanical systems; adjustment for achieving the electrical accuracy for various electrical systems. The assembling steps from the various sub-systems into the exposure apparatus include mechanical connections, wire connections of electric circuits, pipe connections of pneumatic circuits, etc. between the various sub-systems. It is needless to mention that there are assembling steps of the individual sub-systems, before the assembling steps from the various sub-systems into the exposure apparatus. After completion of the assembling steps from the various sub-systems into the exposure apparatus, overall adjustment is carried out to ensure various accuracies as the entire exposure apparatus. The manufacture of exposure apparatus is desirably performed in a clean room in which the temperature, cleanliness, etc. are controlled.

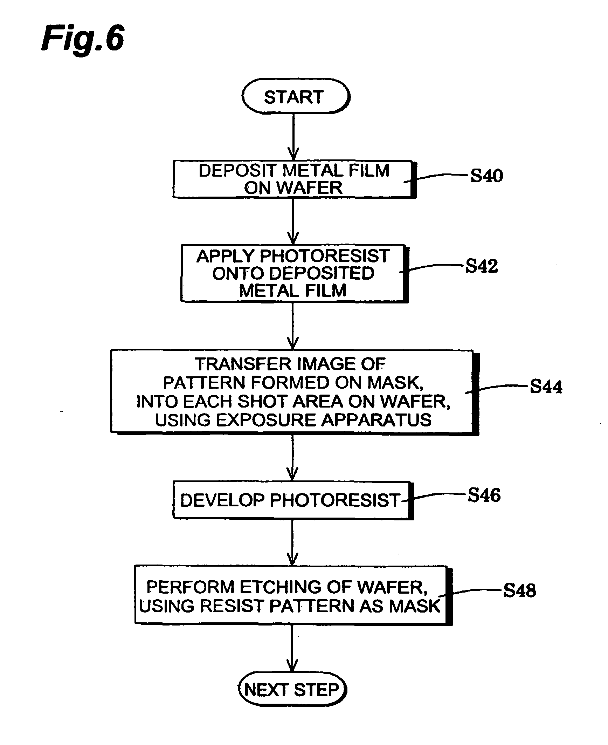

The following will describe a device manufacturing method using the exposure apparatus of the above embodiment. Fig. 6 is a flowchart showing manufacturing steps of semiconductor devices. As shown in Fig. 6, the manufacturing steps of semiconductor devices include depositing a metal film on a wafer W to become a substrate for semiconductor devices (step S40); and applying a photoresist as a photosensitive material onto the deposited metal film (step S42). The subsequent steps include transferring a pattern formed on a mask (reticle) M, into each shot area on the wafer W, using the projection exposure apparatus of the above embodiment (step S44: exposure step); and performing development of the wafer W after completion of the transfer, i.e., development of the photoresist onto which the pattern has been transferred (step S46: development step). A step subsequent thereto is to process the surface of the wafer W by etching or the like, using the resist pattern made on the surface of the wafer W in step S46, as a mask (step S48: processing step).

The resist pattern herein is a photoresist layer in which projections and depressions are formed in the shape corresponding to the pattern transferred by the projection exposure apparatus of the above embodiment, and which the depressions penetrate throughout. In the step S48, the surface of the wafer W is processed through this resist pattern. The processing carried out in the step S48 includes, for example, at least either etching of the surface of the wafer W or deposition of a metal film or the like. In the step S44, the projection exposure apparatus of the above embodiment performs the transfer of the pattern using the wafer W coated with the photoresist, as a photosensitive substrate or plate P.

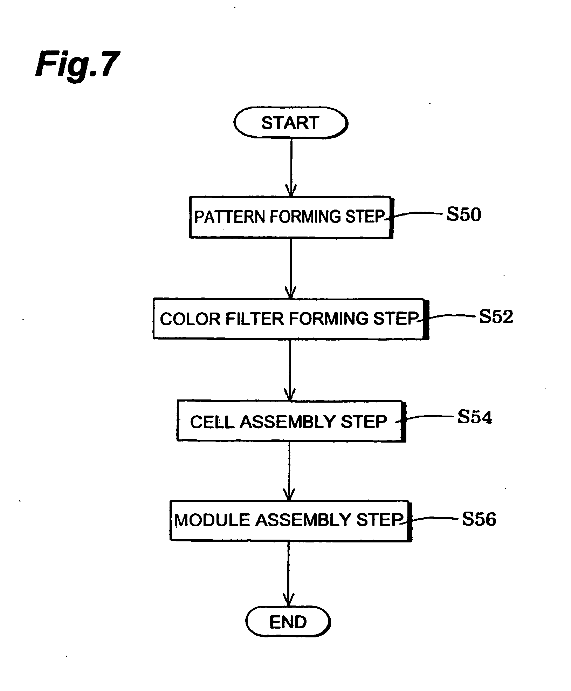

Fig. 7 is a flowchart showing manufacturing steps of a liquid crystal device such as a liquid-crystal display device. As shown in Fig. 7, manufacturing steps of the liquid crystal device include sequentially carrying out a pattern forming step (step S50), a color filter forming step (step S52), a cell assembly step (step S54), and a module assembly step (step S56).

The pattern forming step of step S50 is to form a predetermined pattern such as a circuit pattern and an electrode pattern on a glass substrate coated with a photoresist, as a plate P, using the projection exposure apparatus of the above embodiment. This pattern forming step includes an exposure step of transferring a pattern onto a photoresist layer by means of the projection exposure apparatus of the above embodiment; a development step of developing the plate P after the transfer of the pattern, i.e., developing the photoresist layer on the glass substrate, to make the photoresist layer in the shape corresponding to the pattern; and a processing step of processing the surface of the glass substrate through the developed photoresist layer.

The color filter forming step of step S52 is to form a color filter in a configuration wherein a large number of sets of three dots corresponding to R (Red), G (Green), and B (Blue) are arrayed in a matrix pattern, or in a configuration wherein a plurality of sets of three stripe filters of R, G, and B are arrayed in a horizontal scan direction.

The cell assembly step of step S54 is to assemble a liquid crystal panel (liquid crystal cell) using the glass substrate with the predetermined pattern thereon in step S50 and the color filter formed in step S52. Specifically, the liquid crystal panel is formed, for example, by pouring a liquid crystal into between the glass substrate and the color filter. The module assembly step of step S56 is to attach various components such as electric circuits and backlights for display operation of this liquid crystal panel, to the liquid crystal panel assembled in step S54.

The present invention is not limited to the application to the exposure apparatus for manufacture of semiconductor devices, but can also be widely applied, for example, to the exposure apparatus for display devices such as liquid-crystal display devices formed with rectangular glass plates, or plasma displays and to the exposure apparatus for manufacture of various devices such as imaging devices (CCDs or the like), micromachines, thin-film magnetic heads, and DNA chips. Furthermore, the present invention can also be applied to the exposure step (exposure apparatus) in manufacture of masks (photomasks, reticles, etc.) with mask patterns of various devices by photolithography.

The aforementioned embodiment used the ArF excimer laser light (the wavelength: 193 nm) or the KrF excimer laser light (the wavelength: 248 nm) as the exposure light, but the exposure light does not have to be limited to these: the present invention can also be applied to any other appropriate laser light source, e.g., an F₂ laser light source which supplies the laser light at the wavelength of 157 nm.

The aforementioned embodiment was the application of the present invention to the illumination optical apparatus to illuminate the mask in the exposure apparatus, but, without having to be limited to this, the present invention can also be applied to any commonly-used illumination optical apparatus to illuminate an illumination target surface other than the mask. The aforementioned embodiment used the diffractive optical element, but the present invention is not limited to the diffractive optical element; for example, it is also possible to use a means like a refracting optical element disclosed in European Patent Application Publication EP 1970943.
In the foregoing embodiment, it is also possible to apply the so-called liquid immersion method, which is a technique of filling a medium (typically, a liquid) with a refractive index larger than 1.1 in the optical path between the projection optical system and the photosensitive substrate. In this case, the technique of filling the liquid in the optical path between the projection optical system and the photosensitive substrate can be selected from the technique of locally filling the liquid as disclosed in PCT International Publication No. WO99/49504 the technique of moving a stage holding a substrate as an exposure target in a liquid bath as disclosed in Japanese Patent Application Laid-Open No. 6-124873, the technique of forming a liquid bath in a predetermined depth on a stage and holding the substrate therein as disclosed in Japanese Patent Application Laid-Open No. 10-303114, and so on.
In the foregoing embodiment, it is also possible to apply the so-called polarized illumination method disclosed in U.S Pat. Published Application Nos. 2006/0170901 and 2007/0146676.

It should be noted that the embodiment explained above was described for easier understanding of the present invention but not for restricting the present invention. Therefore, each of the elements disclosed in the embodiment is intended to embrace all design changes and equivalents belonging to the technical scope of the present invention. Each of the constituent elements and others in the above embodiment can be applied in any combination or the like.

## Claims

1. An optical unit comprising:
a first optical path in which a spatial light modulato (36) with a plurality of optical elements arranged two-dimensionally and controlled individually can be arranged;
a second optical path being an optical path through which light having traveled through the first optical path does not travel including a mechanism for insertion of an angle distribution providing element (5) including a predetermined fixed pattern on a surface thereof; and
a third optical path being an optical path of light having traveled through both of the first optical path and the second optical path,
wherein when the angle distribution providing element (5) is inserted in the second optical path, an angle distribution is provided to light exited based on light incident to the angle distribution providing element (5)

2. The optical unit according to claim 1, wherein the mechanism of the second optical path includes a space for insertion of the angle distribution providing element.

3. The optical unit according to claim 1 or 2, wherein the angle distribution providing element comprises a substrate including the predetermined fixed pattern.

4. The optical unit according to any one of claims 1 to 3, wherein the spatial light modulator includes a plurality of mirror elements arranged two-dimensionally, and a drive unit to individually control and drive postures of the mirror elements.

5. The optical unit according to claim 4, wherein the drive unit continuously varies orientations of the mirror elements.

6. The optical unit according to any one of claims 1 to 5, further comprising a light splitter to split an incident beam into a plurality of beams,
wherein the first optical path is an optical path of a first beam out of the plurality of beams split by the light splitter, and
wherein the second optical path is an optical path of a second beam out of the plurality of beams split by the light splitter.

7. The optical unit according to any one of claims 1 to 6, further comprising a light combiner to combine the first and second beams,
wherein the third optical path is an optical path of the first and second beams combined by the light combiner.

8. The optical unit according to claim 6 or 7, wherein the light splitter includes a separation film to separate the incident beam into a reflected beam as the first beam and a transmitted beam as the second beam.

9. The optical unit according to any one of claims 6 to 8, wherein the light combiner includes a separation film to separate the first beam having traveled via the spatial light modulator, into a reflected beam as a necessary beam and a transmitted beam as an unnecessary beam.

10. The optical unit according to any one of claims 6 to 9, wherein a traveling direction of the incident beam to the light splitter is parallel to a traveling direction in a standard state of an exiting beam exited from the light combiner.

11. The optical unit according to any one of claims 1 to 10, said optical unit being used in an illumination optical apparatus to illuminate an illumination target surface on the basis of light from a light source,
wherein the third optical path is coincident with or parallel to an optical axis of the illumination optical apparatus.

12. The optical unit according to claim 10, said optical unit being used in an illumination optical apparatus to illuminate an illumination target surface on the basis of light from a light source,
wherein the traveling direction in the standard state of the exiting beam is coincident with or parallel to an optical axis of the illumination optical apparatus.

13. An illumination optical apparatus which illuminates an illumination target surface on the basis of light from a light source, the illumination optical apparatus comprising:
the optical unit as set forth in any one of claims 1 to 12; and
a distribution forming optical system (6,9,11) which forms a predetermined light intensity distribution on an illumination pupil of the illumination optical apparatus, based on light having traveled via the spatial light modulator and via the angle distribution providing element.

14. The illumination optical apparatus according to claim 13, further comprising: an illumination pupil distribution measuring unit (12) to perform measurement of the predetermined light intensity distribution formed on the illumination pupil, on the illumination pupil or on a plane optically conjugate with the illumination pupil; and a control unit to control the spatial light modulator in the optical unit, based on a result of the measurement by the illumination pupil measuring unit.

15. An exposure apparatus comprising the illumination optical apparatus as set forth in claim 13 or 14 for illuminating a predetermined pattern, the exposure apparatus performing exposure of the predetermined pattern on a photosensitive substrate.

16. A device manufacturing method comprising:
an exposure step of effecting the exposure of the predetermined pattern on the photosensitive substrate, using the exposure apparatus as set forth in claim 15;
a development step of developing the photosensitive substrate onto which the pattern has been transferred, to form a mask layer in a shape corresponding to the pattern on a surface of the photosensitive substrate; and
a processing step of processing the surface of the photosensitive substrate through the mask layer.

17. An exposure method of effecting exposure of a predetermined pattern on a photosensitive substrate on the basis of light from a light source, the exposure method comprising:
a first step of guiding the light from the light source to an angle distribution providing element to form a predetermined pupil intensity distribution on an illumination pupil;
a second step of splitting the light from the light source into a first beam and a second beam different from the first beam, the second beam being directed toward the angle distribution providing element;
a third step of guiding the first beam to a spatial light modulator with a plurality of optical elements arranged two-dimensionally and controlled individually;
a fourth step of guiding the first beam having traveled via the spatial light modulator, to a position of the illumination pupil;
a fifth step of illuminating the predetermined pattern with light having traveled via the illumination pupil; and
a sixth step of performing the exposure on the photosensitive substrate on the basis of light from the predetermined pattern thus illuminated.

18. The exposure method according to claim 17, further comprising:
a seventh step of performing measurement of the predetermined light intensity distribution formed on the illumination pupil; and
an eighth step of controlling light modulation by the spatial light modulator, based on a result of the measurement in the seventh step.

19. The exposure method according to claim 17 or 18, further comprising:
a ninth step of measuring an exposed pattern transferred onto the photosensitive substrate;
a tenth step of determining whether the exposed pattern is within a permissible range; and
an eleventh step of controlling light modulation by the spatial light modulator when it is determined in the tenth step that the exposed pattern is off the permissible range.

20. An electronic device manufacturing method comprising:
an exposure step of effecting the exposure of the predetermined pattern on the photosensitive substrate, using the exposure method as set forth in any one of claims 17 to 19;
a development step of developing the photosensitive substrate onto which the pattern has been transferred, to form a mask layer in a shape corresponding to the pattern on a surface of the photosensitive substrate; and
a processing step of processing the surface of the photosensitive substrate through the mask layer.

## Patentansprüche

1. Optische Einheit, mit:
einem ersten optischen Pfad, in dem ein Raumlichtmodulator (36) mit einer Vielzahl von zweidimensional angeordneten und einzeln gesteuerten optischen Elementen angeordnet werden kann;
einem zweiten optischen Pfad, der ein optischer Pfad ist, durch den sich kein Licht bewegt, das sich durch den ersten optischen Pfad bewegt hat, mit einem Einführmechanismus für ein Winkelverteilungsbereitstellungselement (5), das auf seiner Fläche eine festgelegte feststehende Struktur aufweist; und
einem dritten optischen Pfad, der ein optischer Pfad für Licht ist, das sich durch den ersten optischen Pfad und den zweiten optischen Pfad bewegt hat,
wobei dem Licht, das anhand von in das Winkelverteilungsbereitstellungselement (5) einfallendes Licht angeregt wird, eine Winkelverteilung bereitgestellt wird, wenn das Winkelverteilungsbereitstellungselement (5) in den zweiten optischen Pfad eingeführt ist.

2. Optische Einheit nach Anspruch 1, bei der der Mechanismus des zweiten optischen Pfads einen Raum zum Einführen des Winkelverteilungsbereitstellungselements aufweist.

3. Optische Einheit nach Anspruch 1 oder 2, bei der das Winkelverteilungsbereitstellungselement ein Substrat einschließlich der festgelegten feststehenden Struktur aufweist.

4. Optische Einheit nach einem der Ansprüche 1 bis 3, bei der der Raumlichtmodulator eine Vielzahl von zweidimensional angeordneten Spiegelelementen aufweist und eine Antriebseinheit, um Stellungen der Spiegelelemente einzeln zu steuern und anzutreiben.

5. Optische Einheit nach Anspruch 4, bei der die Antriebseinheit Ausrichtungen der Spiegelelemente fortlaufend verändert.

6. Optische Einheit nach einem der Ansprüche 1 bis 5, des Weiteren mit einem Lichtteiler, um einen einfallenden Strahl in eine Vielzahl von Strahlen zu teilen,
wobei der erste optische Pfad ein optischer Pfad eines ersten Strahls aus der Vielzahl von Strahlen ist, die durch den Lichtteiler geteilt worden sind, und
wobei der zweite optische Pfad ein optischer Pfad eines zweiten Strahls aus der Vielzahl von Strahlen ist, die durch den Lichtteiler geteilt worden sind.

7. Optische Einheit nach einem der Ansprüche 1 bis 6, des Weiteren mit einem Lichtkombinator, um den ersten und zweiten Strahl zu kombinieren,
wobei der dritte optische Pfad ein optischer Pfad des ersten und zweiten Strahls ist, die durch den Lichtkombinierer kombiniert worden sind.

8. Optische Einheit nach Anspruch 6 oder 7, bei der der Lichtteiler eine Trennschicht aufweist, um den einfallenden Strahl in einen reflektierten Strahl als ersten Strahl und einen weitergeleiteten Strahl als zweiten Strahl zu trennen.

9. Optische Einheit nach einem der Ansprüche 6 bis 8, bei der der Lichtkombinator eine Trennschicht oder Trennfolie aufweist, um den ersten Strahl, der sich über den Raumlichtmodulator bewegt hat, in einen reflektierten Strahl als notwendigen Strahl und einen weitergeleiteten Strahl als nicht notwendigen Strahl zu trennen.

10. Optische Einheit nach einem der Ansprüche 6 bis 9, bei der eine Bewegungsrichtung des auf den Lichtteiler einfallenden Strahls parallel zu einer Bewegungsrichtung in einem Grundzustands eines angeregten Strahls ist, der durch den Lichtkombinierer angeregt worden ist.

11. Optische Einheit nach einem der Ansprüche 1 bis 10, wobei die optische Einheit in einer optischen Beleuchtungsvorrichtung verwendet wird, um eine Beleuchtungszielfläche anhand von Licht einer Lichtquelle zu beleuchten,
wobei der dritte optische Pfad mit einer optischen Achse der optischen Beleuchtungsvorrichtung zusammenfällt oder parallel dazu ist.

12. Optische Einheit nach Anspruch 10, wobei die optische Einheit in einer optischen Beleuchtungsvorrichtung verwendet wird, um eine Beleuchtungszielfläche anahnd von Licht von einer Lichtquelle zu beleuchten, wobei die Bewegungsrichtung im Grundzustand des angeregten Strahls mit einer optischen Achse der optischen Beleuchtungsvorrichtung zusammenfällt oder parallel zu ihr ist.

13. Optische Beleuchtungsvorrichtung, die eine Beleuchtungszielfläche anhand von Licht von einer Lichtquelle beleuchtet, die optische Beleuchtungsvorrichtung mit:
der optischen Einheit nach einem der Ansprüche 1 bis 12; und
einem eine Verteilung ausbildenden optischen System (6, 9, 11), das eine festgelegte Lichtintensitätsverteilung auf einer Beleuchtungspupille der optischen Beleuchtungsvorrichtung anhand von Licht ausbildet, das sich durch den Raumlichtmodulator und durch das Winkelverteilungsbereitstellungselement bewegt hat.

14. Optische Beleuchtungsvorrichtung nach Anspruch 13, des Weiteren mit:
einer Beleuchtungspupillenverteilungsmesseinheit (12), um eine Messung der festgelegten Lichtintensitätsverteilung auszuführen, die auf der Beleuchtungspupille, auf der Beleuchtungspupille oder auf einer mit der Beleuchtungspupille optisch gepaarten Ebene ausgebildet ist; und einer Reglereinheit, um den Raumlichtmodulator in der optischen Einheit basierend auf einem Ergebnis der Messung durch die Beleuchtungspupillenmesseinheit zu steuern.

15. Belichtungsvorrichtung mit einer optischen Beleuchtungsvorrichtung nach Anspruch 13 oder 14 zum Beleuchten einer festgelegten Struktur, wobei die Belichtungsvorrichtung eine Belichtung der festgelegten Struktur auf einem lichtempfindlichen Substrat ausführt.

16. Herstellungsverfahren für eine Einrichtung, mit:
einem Belichtungsschritt zum Bewirken der Belichtung der festgelegten Struktur auf dem lichtempfindlichen Substrat unter Verwendung der Belichtungsvorrichtung nach Anspruch 15;
einem Entwicklungsschritt zum Entwickeln des lichtempfindlichen Substrats auf das die Struktur übertragen worden ist, um eine Maskierungsschicht mit einer Form, die der Struktur entspricht, auf einer Fläche des lichtempfindlichen Substrats auszubilden; und
einem Verarbeitungsschritt zum Verarbeiten der Fläche des lichtempfindlichen Substrats durch die Maskierungsschicht.

17. Belichtungsverfahren zum Bewirken der Belichtung einer festgelegten Struktur auf einem lichtempfindlichen Substrat auf Grundlage von Licht von einer Lichtquelle, das Belichtungsverfahren umfassend:
einen ersten Schritt zum Leiten des Lichts von der Lichtquelle zu einem Winkelverteilungsbereitstellungselement, um eine festgelegte Pupillenintensitätsverteilung auf einer Beleuchtungspupille auszubilden;
einen zweiten Schritt zum Aufteilen des Lichts von der Lichtquelle in einen ersten Strahl und einen zu dem ersten Strahl unterschiedlichen zweiten Strahl, wobei der zweite Strahl in Richtung des Winkelverteilungsbereitstellungselements gerichtet ist;
einen dritten Schritt zum Führen des ersten Strahls zu einem Raumlichtmodulator mit einer Vielzahl von zweidimensional angeordneten und einzeln gesteuerten optischen Elementen;
einen vierten Schritt zum Führen des ersten Strahls, der sich durch den Raumlichtmodulator bewegt hat, zu einer Position der Beleuchtungspupille;
einen fünften Schritt zum Beleuchten der festgelegten Struktur mit Licht, das sich durch die Beleuchtungspupille bewegt hat; und
einen sechsten Schritt zum Ausführen der Belichtung des lichtempfindlichen Substrats anhand von Licht der so beleuchteten festgelegten Struktur.

18. Belichtungsverfahren nach Anspruch 17, des Weiteren mit:
einem siebten Schritt zum Ausführen einer Messung der festgelegten Lichtintensitätsverteilung, die auf der Beleuchtungspupille ausgebildet ist; und
einem achten Schritt zum Regeln der Lichtmodulation durch den Raumlichtmodulator auf Grundlage eines Ergebnisses der Messung aus dem siebten Schritt.

19. Belichtungsverfahren nach Anspruch 17 oder 18, des Weiteren mit:
einem neunten Schritt zum Messen einer belichteten Struktur, die auf das lichtempfindliche Substrat übertragen worden ist;
einem zehnten Schritt zum Bestimmen, ob die belichtete Struktur innerhalb eines zulässigen Bereichs ist; und
einem elften Schritt zum Regeln der Lichtmodulation durch den Raumlichtmodulator, wenn in dem zehnten Schritt bestimmt worden ist, dass die belichtete Struktur außerhalb des zulässigen Bereichs ist.

20. Herstellungsverfahren für eine elektronische Einrichtung, mit:
einem Belichtungsschritt zum Bewirken der Belichtung der festgelegten Struktur auf dem lichtempfindlichen Substrat unter Verwendung des Belichtungsverfahrens nach einem der Ansprüche 17 bis 19;
einem Entwicklungsschritt zum Entwickeln des lichtempfindlichen Substrats auf das die Struktur übertragen worden ist, um eine Maskierungsschicht in einer Form auszubilden, die zu der Struktur auf einer Fläche des lichtempfindlichen Substrats korrespondiert; und
einem Verarbeitungsschritt zum Verarbeiten der Fläche des lichtempfindlichen Substrats durch die Maskierungsschicht.

## Revendications

1. Unité optique, comprenant :
un premier chemin optique dans lequel un modulateur spatial de lumière (36) ayant une pluralité d'éléments optiques disposés de manière bidimensionnelle et commandés individuellement peut être disposé ;
un deuxième chemin optique étant un chemin optique à travers lequel la lumière qui s'est propagée à travers le premier chemin optique ne se propage pas comportant un mécanisme pour l'insertion d'un élément (5) de distribution angulaire, comportant un motif fixe prédéterminé sur sa surface ; et
un troisième chemin optique étant un chemin optique de la lumière ayant traversé le premier chemin optique et le deuxième chemin optique,
où lorsque l'élément (5) fournissant une distribution angulaire est inséré dans le deuxième chemin optique, une distribution angulaire est prévue pour la lumière délivrée en sortie sur la base de la lumière incidente sur l'élément (5) fournissant une distribution angulaire.

2. Unité optique selon la revendication 1, dans laquelle le mécanisme du deuxième chemin optique comporte un espace pour l'insertion de l'élément fournissant la distribution angulaire.

3. Unité optique selon la revendication 1 ou 2, dans laquelle l'élément fournissant la distribution angulaire comprend un substrat comportant le motif fixe prédéterminé.

4. Unité optique selon l'une quelconque des revendications 1 à 3, dans laquelle le modulateur spatial de lumière comporte une pluralité d'éléments de miroir disposés de manière bidimensionnelle, et une unité d'entraînement pour entraîner et commander individuellement les postures des éléments de miroir.

5. Unité optique selon la revendication 4, dans laquelle l'unité d'entraînement fait varier en continu les orientations des éléments de miroir.

6. Unité optique selon l'une quelconque des revendications 1 à 5, comprenant en outre un diviseur de lumière pour diviser un faisceau incident en une pluralité de faisceaux,
où le premier chemin optique est un chemin optique d'un premier faisceau parmi la pluralité de faisceaux divisés par le diviseur de lumière, et
où le deuxième chemin optique est un chemin optique d'un deuxième faisceau parmi la pluralité de faisceaux divisés par le diviseur de lumière.

7. Unité optique selon l'une quelconque des revendications 1 à 6, comprenant en outre un combinateur de lumière pour combiner les premier et deuxième faisceaux,
où le troisième chemin optique est un chemin optique des premier et deuxième faisceaux combinés par le combinateur de lumière.

8. Unité optique selon la revendication 6 ou 7, dans laquelle le diviseur de lumière comporte un film de séparation pour séparer le faisceau incident en un faisceau réfléchi en tant que premier faisceau et en un faisceau transmis en tant que deuxième faisceau.

9. Unité optique selon l'une quelconque des revendications 6 à 8, dans laquelle le combinateur de lumière comporte un film de séparation pour séparer le premier faisceau se propageant au moyen du modulateur spatial de lumière, en un faisceau réfléchi en tant que faisceau nécessaire et un faisceau transmis en tant que faisceau inutile.

10. Unité optique selon l'une quelconque des revendications 6 à 9, dans laquelle une direction de propagation du faisceau incident vers le diviseur de lumière est parallèle à une direction de propagation à l'état standard d'un faisceau sortant, délivré en sortie par le combinateur de lumière.

11. Unité optique selon l'une quelconque des revendications 1 à 10, ladite unité optique étant utilisée dans un appareil optique d'éclairage pour éclairer une surface d'éclairage cible sur la base de l'illumination de la lumière provenant d'une source de lumière,
où le troisième chemin optique coïncide avec à un axe optique de l'appareil optique d'éclairage ou lui est parallèle.

12. Unité optique selon la revendication 10, ladite unité optique étant utilisée dans un appareil optique d'éclairage pour éclairer une surface d'éclairage cible sur la base de la lumière provenant d'une source de lumière,
où la direction de propagation à l'état standard du faisceau sortant coïncide avec un axe optique de l'appareil optique d'éclairage ou lui est parallèle.

13. Appareil optique d'éclairage qui éclaire une surface d'éclairage cible sur la base de la lumière provenant d'une source de lumière, l'appareil optique d'éclairage comprenant :
l'unité optique selon l'une quelconque des revendications 1 à 12 ; et
un système optique (6, 9, 11) de formation de distribution qui forme une distribution prédéterminée de l'intensité lumineuse sur une pupille d'éclairage de l'appareil optique d'éclairage, sur la base de la lumière se propageant au moyen du modulateur spatial de lumière et au moyen de l'élément fournissant la distribution angulaire.

14. Appareil optique d'éclairage selon la revendication 13, comprenant en outre :
une unité de mesure (12) de la distribution de la pupille d'éclairage pour exécuter une mesure de la distribution prédéterminée de l'intensité lumineuse formée sur la pupille d'éclairage, sur la pupille d'éclairage ou sur un plan optiquement conjugué avec la pupille d'éclairage ; et une unité de commande pour commander le modulateur spatial de lumière dans l'unité optique, sur la base d'un résultat de la mesure par l'unité de mesure de la pupille d'éclairage.

15. Appareil d'exposition comprenant l'appareil optique d'éclairage selon la revendication 13 ou 14 pour éclairer un motif prédéterminé, l'appareil d'exposition effectuant une exposition du motif prédéterminé sur un substrat photosensible.

16. Procédé de fabrication de dispositif comprenant :
une étape d'exposition pour effectuer l'exposition du motif prédéterminé sur le substrat photosensible en utilisant l'appareil d'exposition suivant la revendication 15 ;
une étape de développement consistant à développer le substrat photosensible sur lequel le motif a été transféré, afin de former une couche de masque sous une forme correspondant au motif sur une surface du substrat photosensible ; et
une étape de traitement traitant la surface du substrat photosensible à travers la couche de masque.

17. Procédé d'exposition pour effectuer une exposition d'un motif prédéterminé sur un substrat photosensible sur la base de la lumière provenant d'une source de lumière, le procédé d'exposition comprenant :
une première étape consistant à guider la lumière provenant de la source de lumière vers un élément fournissant la distribution angulaire pour former une distribution prédéterminée de l'intensité de pupille sur une pupille d'éclairage ;
une deuxième étape consistant à diviser la lumière provenant de la source de lumière en un premier faisceau et en un deuxième faisceau différent du premier faisceau, le deuxième faisceau étant dirigé vers l'élément fournissant la distribution angulaire ;
une troisième étape consistant à guider le premier faisceau vers un modulateur spatial de lumière avec une pluralité d'éléments optiques disposés de manière bidimensionnelle et commandés individuellement ;
une quatrième étape consistant à guider le premier faisceau se propageant au moyen du modulateur spatial de lumière, vers une position de la pupille d'éclairage ;
une cinquième étape consistant à éclairer le motif prédéterminé avec une lumière se propageant au moyen de la pupille d'éclairage ; et
une sixième étape consistant à effectuer l'exposition sur le substrat photosensible sur la base de la lumière provenant du motif prédéterminé ainsi éclairé.

18. Procédé d'exposition selon la revendication 17, comprenant en outre :
une septième étape consistant à exécuter une mesure de la distribution prédéterminée de l'intensité lumineuse formée sur la pupille d'éclairage ; et
une huitième étape consistant à commander la modulation de la lumière par le modulateur spatial de lumière, sur la base d'un résultat de la mesure dans la septième étape.

19. Procédé d'exposition selon la revendication 17 ou 18, comprenant en outre :
une neuvième étape consistant à mesurer un motif exposé transféré sur le substrat photosensible ;
une dixième étape consistant à déterminer si le motif exposé est dans plage admissible ; et
une onzième étape consistant à commander la modulation de la lumière par le modulateur spatial de lumière lorsque l'on détermine dans la dixième étape que le motif exposé n'est pas dans la plage admissible.

20. Procédé de fabrication d'un dispositif électronique comprenant :
une étape d'exposition pour effectuer l'exposition du motif prédéterminé sur le substrat photosensible, en utilisant le procédé d'exposition selon l'une des revendications 17 à 19 ;
une étape de développement pour développer le substrat photosensible sur lequel le motif a été transféré, afin de former une couche de masque en une forme correspondant au motif sur une surface du substrat photosensible ; et
une étape de traitement pour traiter la surface du substrat photosensible à travers la couche de masque.
